# FASCICULE DE BREVET EUROPEEN

(11) **EP 2 083 470 B1**
(45) Date de publication et mention de la délivrance du brevet: **05.06.2013**
(21) Numéro de dépôt: 09150899.4
(22) Date de dépôt: 20.01.2009
(51) Int. Cl.: H01P 1/38, H05K 5/02, H05K 1/02, H05K 3/34

(54) **Composant électronique à montage en surface à connexion électrique positionnée avec précision**
Elektronisches Bauteil zur Montage auf der präzise positionierten elektrischen Verbindungsfläche
Electronic component with surface installation with precisely positioned electric connection

(30) Priorité: 24.01.2008 FR 0850428
(43) Date de publication de la demande: 29.07.2009
(73) Titulaire: Chelton Telecom & Microwave, 91140 Villebon Sur Yvette (FR)
(72) Inventeur: Reihs, Jean-Claude, 92400 Courbevoie (FR)
(74) Mandataire: Ilgart, Jean-Christophe

(56) Documents cités:
- EP-A- 0 712 266
- EP-A- 1 001 493
- FR-A- 2 879 828
- JP-A- 8 051 305
- US-A1- 2002 167 371
- US-A1- 2004 164 816

## Description

### DOMAINE TECHNIQUE

La présente invention est relative à un composant électronique à montage en surface (technologie CMS) et plus particulièrement un composant électronique hyperfréquence tel un isolateur et/ou un circulateur éventuellement associé à une ou plusieurs fonctions telles qu'un filtre, un limiteur de puissance.

### ÉTAT DE LA TECHNIQUE ANTÉRIEURE

En hyperfréquence, les circulateurs sont des composants non réciproques à trois ports qui permettent la séparation de signaux selon leur sens de propagation. Par exemple, ils permettent l'aiguillage des signaux entre une antenne et le circuit d'émission d'une part et le circuit de réception d'autre part.

Les isolateurs sont aussi des composants non réciproques à deux ports d'accès qui permettent la propagation de signaux selon un sens de propagation et qui l'empêche selon l'autre sens. La principale utilisation est le découplage entre un générateur hyperfréquence et sa charge pour empêcher tout retour d'énergie vers le générateur.

Ces composants électroniques à montage en surface comportent classiquement un boîtier mécanique avec une partie inférieure incluant un fond et une partie supérieure ou capot, devant contenir une cavité électromagnétique résonante, cette cavité contenant un empilement avec un circuit électronique central et de part et d'autre un élément en ferrite, au moins un plan de masse, un aimant. Le circuit électronique central comporte par exemple des tronçons de lignes coplanaires se terminant par autant de zones de connexion que le composant a de ports.

Des plots de connexion sont destinés à assurer l'interconnexion électrique du composant électronique avec un circuit imprimé sur lequel il doit être monté. Ces plots de connexion sont connectés d'un côté à une zone de connexion du circuit électronique et sont accessibles de l'autre à l'extérieur du boîtier mécanique de manière à pouvoir être brasés à une piste du circuit imprimé.

L'utilisation de fréquences toujours plus élevées impose une réduction de la taille des composants puisque leur taille est inversement proportionnelle à la fréquence. Les cartes de circuits imprimés sont elles aussi de plus en plus miniaturisées. On emploie maintenant des composants électroniques hyperfréquences dont les dimensions latérales hors tout du boîtier sont de l'ordre de un à deux centimètres et dont l'épaisseur est inférieure au centimètre.

Le montage de ces composants électroniques sur les cartes de circuit imprimés fait appel à des techniques automatisées dans des fours à passage pour CMS, toute la surface du fond du boîtier étant brasée sur le circuit imprimé. Il est donc nécessaire que les composants aient une géométrie définie avec la plus grande précision possible et que leur positionnement soit également le plus précis possible pour obtenir une connexion électrique précise et reproductible du circuit électronique central sur le circuit imprimé. Compte tenu des fréquences auxquelles de tels composants fonctionnent et donc de la petitesse du boîtier du composant, il est de plus en plus difficile de positionner avec précision, dans les trois dimensions, les plots de connexion pour qu'ils coïncident au mieux avec les pistes du circuit imprimé. Si la précision n'est pas obtenue, il y a des risques de fragilisation de la brasure donc la fiabilité de l'assemblage est réduite. Des risques de court-circuit entre pistes du circuit imprimé peuvent également survenir. De plus, des ruptures d'impédance peuvent apparaître, ce qui se traduit par des pertes importantes dans le circuit électronique hyperfréquence.

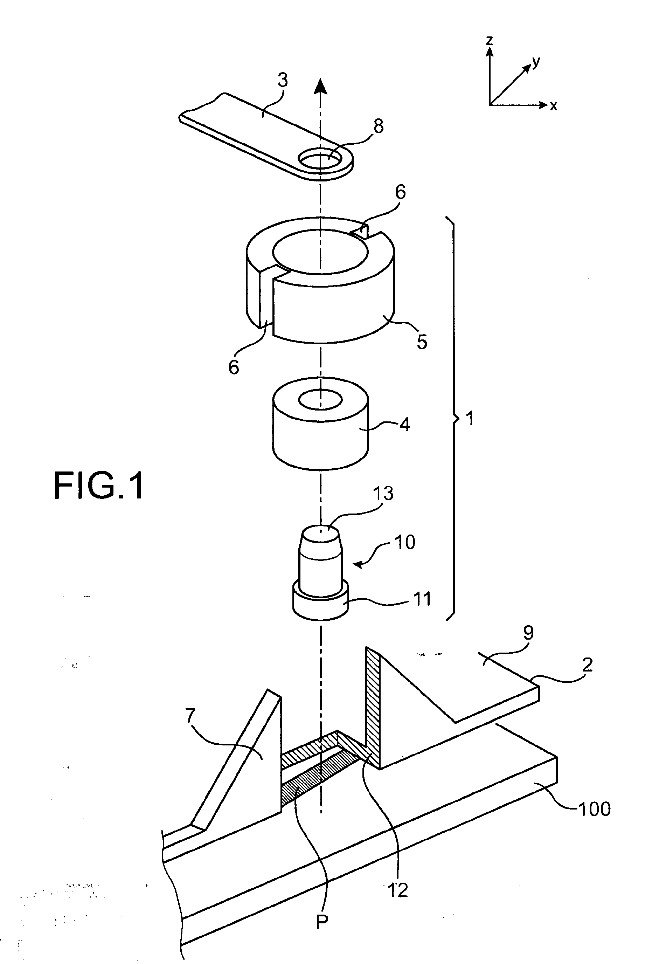

On connaît par la demande de brevet FR-A-2 879 828, un composant hyperfréquence avec des plots de connexion 1 formés chacun d'une partie conductrice centrale 10 sensiblement cylindrique destinée à être reliée électriquement à une zone de connexion 3 du circuit électronique central (non représenté). On se réfère à la figure 1 qui montre une vue éclatée du montage d'un plot de connexion 1 par rapport au fond 9 du boîtier 2. La partie conductrice centrale 10 du plot 1 est insérée dans un élément isolant électrique 4, l'élément isolant électrique 4 étant lui-même inséré dans des moyens de positionnement 5 vis à vis du bord du fond 9 du boîtier 2.

Sur cette figure 1, le plot de connexion 1 est représenté avec une partie conductrice centrale 10 sensiblement en forme de clou pourvue d'une âme centrale 13 se terminant par une tête 11. L'âme centrale 13 est destinée à être reliée électriquement à une zone de connexion 3 du circuit électronique central. Cette liaison peut se faire au niveau d'un orifice 8 dont est pourvue la zone de connexion 3 du tronçon de ligne coplanaire correspondante. La tête 11 de la partie conductrice centrale 10 est destinée à être reliée électriquement à une piste conductrice P du circuit imprimé 100.

L'élément isolant électrique 4 est représenté en forme de bague sensiblement cylindrique. Les moyens de positionnement 5 sont également en forme de bague sensiblement cylindrique. Ils sont dotés de deux rainures 6, diamétralement opposées, dirigées selon l'axe z.

Lors du montage, les rainures 6 sont destinées à prendre place par gravité dans des glissières 7 solidaires du fond 9 du boîtier 2. Les moyens de positionnement 5 viennent se caler contre le fond 9 du boîtier 2. Les glissières 7 se trouvent en bordure du fond 9, au niveau de la paroi latérale du boîtier 2. Le fond 9 est découpé entre les glissières 7 pour laisser la tête 11 de la partie conductrice centrale 10 se projeter hors du boîtier 2 de manière à pouvoir venir en contact avec la piste P. La découpe est référencée 12.

Les axes de révolution de la partie conductrice centrale 10 et des différentes bagues 5, 4 sont confondus lors du montage. Ils sont dirigés selon l'axe z du repère illustré sur la figure 1. Les rainures 6 des moyens de positionnement 5 et les glissières 7 sont également dirigées selon l'axe z. Cette disposition permet de positionner le plot de connexion 1 avec précision dans le plan x, y, c'est à dire dans le plan du fond du 9 du boîtier 2 ainsi que dans le plan du circuit imprimé 100, une fois que les rainures 6 de la bague 5 sont engagées dans les glissières 7. La tête 11 de l'âme centrale 10 est alors en saillie par rapport au fond 9 du boîtier 2 à l'extérieur du boîtier 2.

Par contre cette structure souffre d'un inconvénient pour le positionnement en hauteur du plot de connexion 1, c'est à dire son positionnement le long de l'axe z, transversalement au fond 9 du boîtier 2. S'il est mal positionné en hauteur, il risque de ne pas venir en contact avec la piste P du circuit imprimé 100.

En effet lors du report du composant électronique sur le circuit imprimé 100, on prévoit une étape de passage au four à une température d'environ 270°C. A cause de la température et du flux de brasure qui se forme, l'élément isolant électrique 4 risque de coulisser dans les moyens de positionnement 5, selon l'axe z, c'est à dire sensiblement transversalement au fond 9 du boîtier 2, et de s'éloigner du circuit imprimé 100. Ce coulissement entraîne également un déplacement, dans le même sens, de la partie conductrice centrale 10 tendant également à l'éloigner du circuit imprimé 100. Le contact électrique entre le plot de connexion 1 et la piste P ne se fait plus.

Un autre inconvénient de ce type de composant électronique est qu'il ne satisfait pas aux exigences de compatibilité électromagnétique parce que le fond 9 du boîtier 2 est largement ouvert à cause de la présence de la découpe 12. Le plot de connexion 1 est accessible à l'intérieur du boîtier 2 même lorsque le boîtier est fermé et que le composant électronique est reporté sur le circuit imprimé 100.

Encore un autre inconvénient est que le boîtier n'est pas étanche à cause notamment de la découpe 12. Il peut être essentiel de prévoir une étanchéité surtout si le circuit imprimé 100 doit être lavé après le report du composant.

### EXPOSÉ DE L'INVENTION

La présente invention a justement pour but de fournir un composant électronique à montage en surface ayant un positionnement dans les trois dimensions, et notamment en hauteur, aussi précis que possible de manière à éviter tout risque d'écart entre ses plots de connexion et les pistes du circuit imprimé sur lequel il va être monté.

Un autre but de l'invention est de fournir un composant électronique qui satisfait aux exigences de compatibilité électromagnétique.

Encore un autre but de l'invention est de fournir un composant électronique possédant un boîtier étanche.

Pour y parvenir, la présente invention propose un composant électronique à montage en surface comportant un boîtier, un circuit électronique logé à l'intérieur du boîtier, au moins deux plots de connexion destinés à assurer une interconnexion électrique entre le circuit électronique et un circuit imprimé sur lequel doit être monté le composant. Chacun des plots de connexion comporte une partie conductrice centrale en forme de clou avec une âme centrale à relier au circuit électronique et une tête, devant assurer un contact électrique avec le circuit imprimé, et un élément isolant électrique qui entoure l'âme centrale de la partie conductrice. Selon l'invention, l'élément isolant électrique est une bague sensiblement cylindrique ayant deux parties de sections différentes définissant un épaulement. Le boîtier possède un fond pourvu d'un trou traversant pour chacun des plots de connexion, ce trou traversant débouchant à l'extérieur du boîtier, dans une zone en retrait externe du fond, l'épaulement de l'élément isolant électrique étant en butée contre la zone en retrait externe, la partie à section la plus faible de l'élément isolant électrique, se projetant à l'intérieur du boîtier à travers le trou traversant, la tête de la partie conductrice centrale et la partie à section la plus grande de l'élément isolant électrique restant à l'extérieur du boîtier.

Ainsi lors d'une étape de passage au four du composant électronique monté sur le circuit imprimé, grâce à l'épaulement de l'élément isolant électrique, le plot de connexion ne peut coulisser transversalement au fond et le contact avec le circuit imprimé est maintenu.

Chaque trou traversant est décalé par rapport au bord du boîtier, ce qui contribue à assurer la compatibilité électromagnétique du composant électronique. On ne retrouve plus les découpes de fond du boîtier qui empêchaient la compatibilité électromagnétique. La partie à section la plus faible de l'élément isolant électrique peut obturer le trou traversant, cela contribue à ce que les exigences de compatibilité électromagnétique soient remplies.

Le fond du boîtier peut comporter de plus, une seconde zone en retrait externe, de surface supérieure à celle de la première zone en retrait externe et qui englobe la première zone en retrait externe, la première zone en retrait externe ayant une profondeur supérieure à celle de la seconde zone en retrait externe. La seconde zone en retrait externe est destinée à accueillir de la brasure de manière à ce qu'elle mouille convenablement la tête de la partie conductrice centrale du plot de connexion.

Le boîtier comporte une partie inférieure comportant le fond et une partie supérieure ou capot qui peut être fixée de manière étanche à la partie inférieure.

Le capot peut être collé à la partie inférieure.

De plus, il peut être fixé avec au moins une vis à la partie inférieure pour améliorer mécaniquement la fixation.

On peut réaliser l'élément isolant électrique du plot de connexion dans un matériau à constante diélectrique sensiblement constante et capable de supporter la température de fonctionnement, par exemple, le Téflon (marque déposée).

On peut réaliser la partie conductrice centrale du plot de connexion, par exemple, en cuivre doré, en laiton doré.

On peut réaliser le boîtier, par exemple, en acier doré ou argenté ou dans un alliage ayant un coefficient de dilatation thermique aussi faible que possible tel que l'Invar, le Dilver, le Kovar.

Le composant électronique peut être un composant électronique hyperfréquence de type circulateur et/ou isolateur éventuellement associés à au moins une fonction telle un filtre, un limiteur de puissance.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
la figure 1 montre, en éclaté, un plot de connexion utilisé dans un composant l'art antérieur et son montage dans le boîtier du composant ;
la figure 2 est une vue en éclaté du composant électronique de l'invention ;
les figures 3A, 3B, 3C montrent, respectivement, la partie conductrice centrale, l'élément isolant électrique du plot de connexion et le plot de connexion du composant électronique de l'invention ;
les figures 4A, 4B sont des vues en trois dimensions du corps du boîtier du composant selon l'invention ;
les figures 5A, 5B, 5C, 5D sont des vues de dessus, de dessous et des coupes du corps du boîtier du composant selon l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

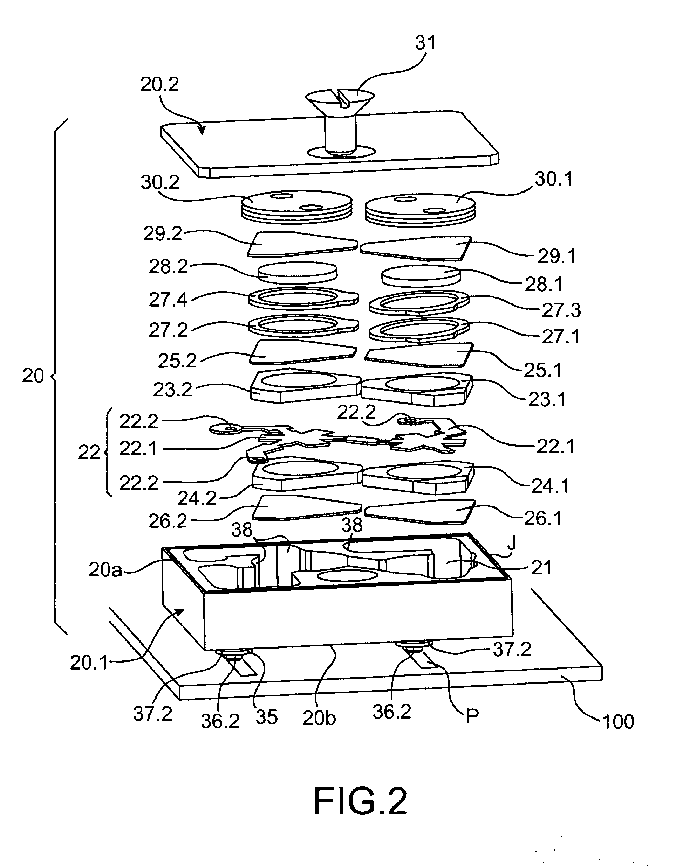

On va se référer à la figure 2 qui montre une vue éclaté d'un exemple de composant électronique à montage en surface selon l'invention. On suppose que dans l'exemple non limitatif décrit, il s'agit d'un circulateur associé à un isolateur. Il comporte un boîtier mécanique 20 en deux parties: une partie inférieure 20.1 ou corps et une partie supérieure 20.2 ou capot. L'intérieur du boîtier 20 contribue à délimiter une cavité électromagnétique 21, dans l'exemple non limitatif décrit, formée de deux parties qui communiquent. Dans la cavité électromagnétique 21 est placé un circuit électronique central 22 comprenant plusieurs tronçons de lignes, par exemple, coplanaires (appelées strip line en anglais) 22.1 se terminant par des zones de connexion 22.2. Les zones de connexion 22.2 sont situées en dehors de la cavité électromagnétique 21 mais restent toutefois à l'intérieur du boîtier 20. On a représenté plusieurs tronçons de lignes coplanaires 22.1 reliés entre eux, chaque tronçon se trouvant dans une partie de cavité 21. Ces zones de connexion 22.2 vont être reliées électriquement par des plots de connexion 35 à l'extérieur du boîtier 20 de manière notamment à permettre l'injection et l'extraction de signaux dans le circuit électronique central 22. Ces zones de connexion sont représentées, dans l'exemple, par des trous traversants.

Dans l'exemple décrit, il y a trois zones de connexion 22.2 parce que le composant électronique décrit est un circulateur associé avec un isolateur. D'autres composants de même technologie pourraient être concernés à savoir un composant mono cellule de type circulateur trois ports, isolateur deux ports associé ou non avec une charge de 50 Ω de puissance, ou un composant hyperfréquence de type circulateur et/ou isolateur éventuellement associés à au moins une fonction telle un filtre, un limiteur de puissance.

Le corps 20.1 du boîtier comporte un fond 20a et des parois 20b. Le fond 20a possède une face interne 20bi et une face externe 20be. Les parois 20a contribuent à délimiter celles de la cavité électromagnétique. Le corps 20.1 du boîtier peut être obtenu par usinage dans une plaque, par exemple d'acier, qui est ensuite argentée. L'usinage permet de délimiter la cavité et de faire les trous traversants. Ainsi la liaison entre le fond 20b et les parois 20a est étanche.

Le circuit électronique central 22 est pris en sandwich entre des éléments en ferrite diélectrique dits supérieurs 23.1, 23.2 et des éléments en ferrite diélectrique dits inférieurs 24.1, 24.2. Il y a deux éléments en ferrite sur un même niveau, un au niveau de chaque partie de cavité 21. Les éléments en ferrite supérieurs 23.1, 23.2 sont situés au dessus du circuit électronique central 22. Les éléments en ferrite inférieurs 24.1, 24.2 sont situés en dessous du circuit électronique central 22. On a représenté deux éléments en ferrite par niveau parce que dans l'exemple on décrit un composant bi cellule avec un circulateur associé à un isolateur.

Des plans de masse intermédiaires et inférieurs prennent en sandwich les éléments en ferrite inférieurs et supérieurs 23.1, 23.2, 24.1, 24.2. Il y a également deux plans de masse par niveau. Ils sont référencés 25.1, 25.2 lorsqu'ils sont dits intermédiaires et qu'ils sont au dessus des éléments en ferrite supérieurs 23.1, 23.2 et ils sont référencés 26.1, 26.2 lorsqu'ils dits inférieurs et qu'ils sont en dessous des éléments en ferrite inférieurs 24.1, 24.2. Les plans de masse inférieurs 26.1, 26.2 reposent sur le fond 20b du boîtier, côté face interne 20bi.

On trouve ensuite au dessus des plans de masse intermédiaires 25.1, 25.2, deux niveaux de plans de masse centreurs 27.1, 27.2, 27.3, 27.4 superposés devant loger des aimants permanents 28.1, 28.2. Il y a également deux plans de masse centreurs par niveau et deux aimants permanents. Les aimants permanents 28.1, 28.2 sont surmontés de plans de masse supérieurs 29.1, 29.2. La partie électronique du circulateur et de l'isolateur, c'est à dire l'empilement que l'on vient de décrire et qui se trouve dans le boîtier 20, est montée en contrainte dans le boîtier 20. On prévoit pour cela, au dessus des plans de masse supérieurs 29.1, 29.2, des couvercles vissés 30.1, 30.2 dans le corps 20.1 du boîtier 20 de manière à fermer les deux parties de la cavité 21. Enfin au dessus, se place le capot 20.2 qui ferme le boîtier 20. Si le boîtier doit être étanche, on fixe le capot 20.2 au corps 20.1 de manière étanche. Cela peut se faire par collage. On a schématisé un joint de colle J qui suit la périphérie du corps 20.1 du boîtier en regard du capot 20.2. Pour renforcer mécaniquement la fixation, on peut prévoir également une fixation avec au moins une vis 31 passant au travers du capot 20.2 et se vissant dans le corps 20.1. Le capot 20.2 peut tout comme le corps 20.1 être réalisé en acier argenté.

Des plots de connexion 35 permettent d'assurer une connexion reproductible et suffisamment précise, en trois dimensions, des tronçons de lignes coplanaires 22.1 du circuit électronique central 22 avec des pistes P portées par un circuit imprimé 100.

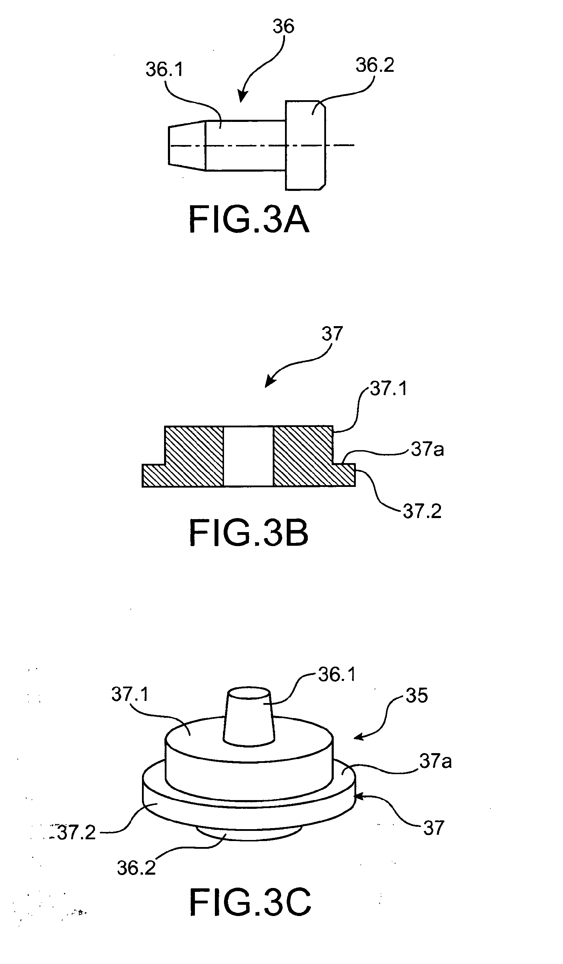

Selon l'invention, un plot de connexion 35 comporte une partie conductrice centrale 36 et une bague d'isolation 37 entourant la partie conductrice centrale 36. On se réfère aux figures 3A, 3B, 3C qui sont sensiblement à la même échelle. La partie conductrice centrale 36 du plot de connexion 35, représentée sur la figure 3A, est en forme de clou avec une âme centrale 36.1 et une tête 36.2. L'âme centrale 36.1 a une extrémité libre et une extrémité reliée à la tête 36.2. La partie conductrice centrale 36 peut être réalisée par exemple en en cuivre doré, en laiton doré.

La bague d'isolation 37 est représentée sur la figure 3B. Cette bague d'isolation 37 est réalisée en matériau diélectrique à constante diélectrique sensiblement constante et capable de supporter la température de fonctionnement (de l'ordre de 280°C), par exemple, le Téflon (marque déposée). Cette bague d'isolation 37 est sensiblement cylindrique et comporte deux parties successives de sections différentes qui définissent un épaulement 37a. La partie de section inférieure est référencée 37.1, la partie de section supérieure est référencée 37.2. Cette bague d'isolation 37 est destinée à s'enfiler autour de l'âme centrale 36.1 de la partie conductrice centrale 36, la partie de section supérieure 37.2 se trouvant du côté de la tête 36.2 comme illustré sur la figure 3C.

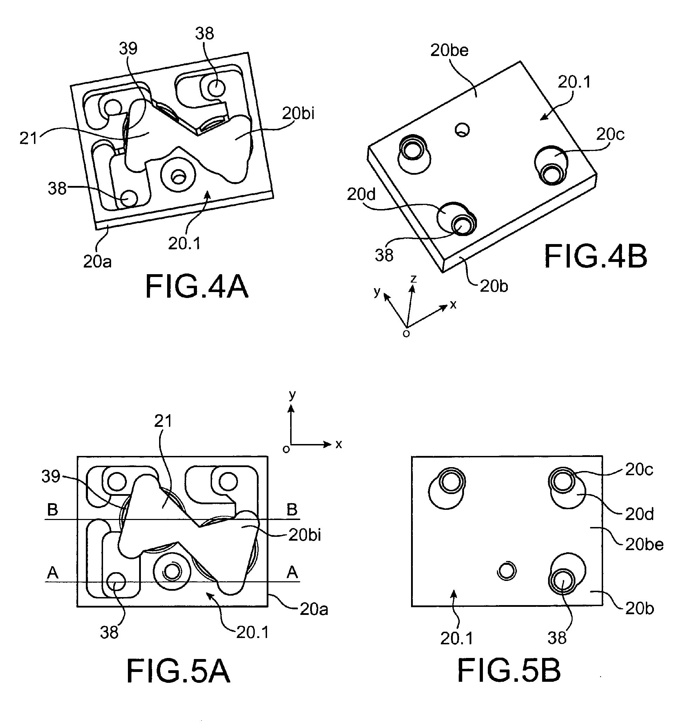

On se réfère maintenant aux figures 4A, 4B ainsi qu'aux figures 5A à 5D qui sont diverses vues du boîtier 20. Il peut être réalisé par exemple en acier doré ou argenté ou dans un alliage ayant un coefficient de dilatation thermique aussi faible que possible tel que l'Invar (acier contenant du nickel et un peu de carbone et de chrome), le Dilver, le Kovar marques déposées (alliage contenant du fer, nickel, cobalt).

Le fond 20b du boîtier est percé d'un trou traversant 38 pour chacun des plots de connexion 35. Chaque trou traversant 38 se trouve au niveau d'une zone en retrait externe 20c du fond 20b. Cette zone sera par la suite appelée première zone en retrait externe 20c lorsque l'on en introduira une autre. La zone en retrait externe 20c est accessible depuis l'extérieur du boîtier 20, depuis la face externe 20be du fond 20b. La zone en retrait externe 20c forme un creux dans l'épaisseur du fond 20b du boîtier 20 qui n'est visible que de l'extérieur du boîtier. La zone en retrait externe 20c borde le trou traversant 38. Lors du montage du plot de connexion 35, l'épaulement 37a de la bague d'isolation 37 vient en butée contre la zone en retrait externe 20c du fond 20b du boîtier 20. La partie de section la plus faible 37.1 de la bague d'isolation 37 passe au travers du trou traversant 38 tandis que la partie de section la plus grande 37.2 reste bloquée à l'extérieur du boîtier 20 par la zone en retrait externe 20c. La partie de section la plus grande 37.2 de l'élément isolant 37 se loge dans la zone en retrait externe 20c. Il est préférable que sa hauteur soit sensiblement inférieure ou égale à la profondeur e1 la zone en retrait externe 20c.

L'âme centrale 36.1 pénètre donc à l'intérieur du boîtier 20 au travers du fond 20b de manière à ce que son extrémité libre vienne en contact électrique avec une zone de connexion. La tête 36.2 de la partie conductrice centrale 36 dépasse par rapport à la partie de section la plus grande 37.2 de l'élément isolant 37. Elle est également à l'extérieur du boîtier 20, et se projette du fond 20b du boîtier 20 vers le circuit imprimé 100, lorsque le composant électronique est posé sur le circuit imprimé 100. La tête 36.2 peut ainsi être mouillée par de la brasure. Cette brasure s'étend sur tout le fond du boîtier 20, ce qui fait que les connexions d'entrée/sorties qui se font grâce aux plots de connexion 35 sont entièrement blindées par un retour de masse complet. Cet aspect contribue une bonne compatibilité électromagnétique du composant électronique.

Grâce à l'épaulement 37a de la bague d'isolation 37 et à la zone en retrait externe 20c du fond 20a du boîtier, aucun déplacement selon l'axe z de la partie conductrice centrale 36 du plot de connexion 35 n'est possible. Le contact électrique avec le circuit imprimé 100 se fait même après l'étape de passage au four. Le trou traversant 38 a pour fonction de positionner le plot de connexion 35 avec précision dans le plan xoy. Le plot de connexion 35 est ainsi positionné avec une grande précision dans les trois dimensions.

Par rapport à l'art antérieur, les trous traversants 38 ne sont plus situés en périphérie de fond 20b, ils sont décalés du bord du fond. De plus, ils sont bouchés par le plot de connexion 35, ce qui fait que les exigences de compatibilité électromagnétique sont remplies au moins au niveau du fond 20b du boîtier 20.

On peut prévoir, dans le fond du boîtier 20b, au niveau de chaque trou traversant 38, une seconde zone en retrait externe 20d, de superficie plus grande que la première zone en retrait externe 20c et qui englobe la première zone en retrait externe 20c. La seconde zone en retrait externe 20d est également accessible depuis l'extérieur du boîtier 20, c'est-à-dire depuis la face externe 20be du fond 20b du boîtier 20. La profondeur e2 de la seconde zone en retrait externe 20d, par rapport à la face externe 20be du fond 20b est inférieure à la profondeur e1 de la première zone en retrait externe 20c par rapport à la face externe 20be du fond 20b du boîtier 20. Cette seconde zone en retrait externe 20d a pour fonction d'accueillir un trop plein de brasure lors du montage du composant électronique sur le circuit imprimé 100 et éviter que cette brasure ne s'infiltre dans des trous d'interconnexion portés par le circuit imprimé. Ces derniers ne sont pas représentés. La brasure rassemblée au niveau de la seconde zone externe mouille convenablement la tête 36.2 de la partie conductrice centrale 36 du plot de connexion 35. La fiabilité de la brasure est ainsi accrue.

Les figures 4A, 4B sont des vues en trois dimensions de la partie inférieure 20.1 du boîtier mécanique 20, montrant d'une part la face interne 20bi du fond 20b, et d'autre part la face externe 20be du fond 20b.

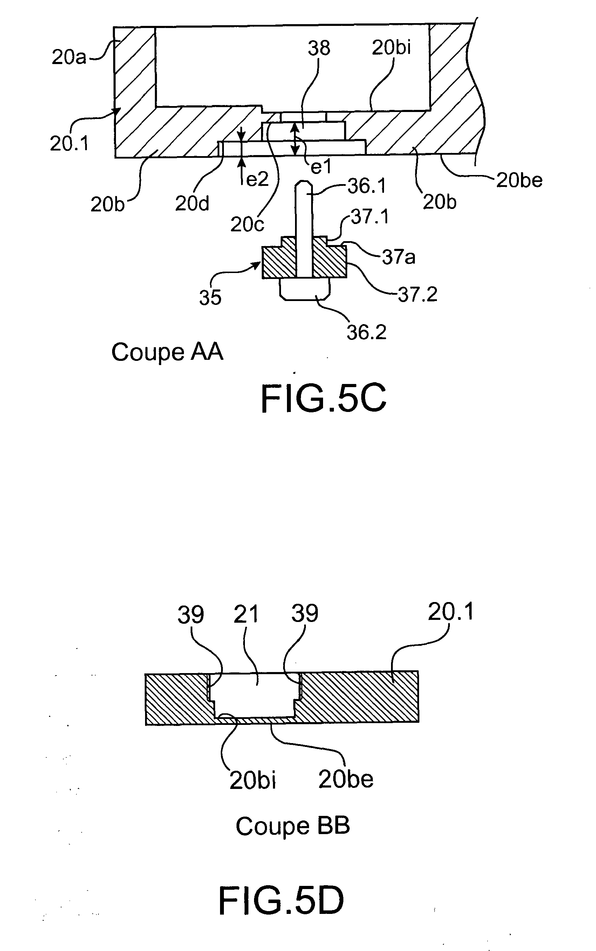

Les figures 5A et 5B sont des vues de dessus et de dessous de la partie inférieure 20.1 du boîtier 20. La figure 5C montre, en coupe, comment le plot de connexion 35 s'insère dans le trou traversant 38 et comment la partie de section la plus faible 37.1 de l'élément isolant 37 obture le trou traversant 38. La figure 5D montre la zone filetée 39 dans le corps 20.1 du boîtier 20 pour accueillir les couvercles vissés 30.1, 30.2.

Bien entendu le composant électronique de l'invention n'est pas limité à un composant hyperfréquence de type circulateur ou isolateur seuls, comme on l'a déjà mentionné plus haut, il peut s'agir en fait de tout composant électronique à montage en surface nécessitant une importante précision de positionnement de ses plots de connexion.

## Revendications

1. Composant électronique à montage en surface comportant un boîtier (20), un circuit électronique (22) logé à l'intérieur du boîtier, au moins deux plots de connexion (35) destinés à assurer une interconnexion électrique entre le circuit électronique (22) et un circuit imprimé (100) sur lequel doit être monté le composant, chacun des plots de connexion (35) comportant une partie conductrice centrale (36) en forme de clou avec une âme centrale (36.1) à relier au circuit électronique (22) et une tête (36.2), devant assurer un contact électrique avec le circuit imprimé (100), et un élément isolant électrique (37) qui entoure l'âme centrale (36.1), **caractérisé en ce que** l'élément isolant électrique (37) est une bague sensiblement cylindrique ayant deux parties (37.1, 37.2) de sections différentes définissant un épaulement (37a), et **en ce que** le boîtier (20) possède un fond (20b) pourvu d'un trou traversant (38) pour chacun des plots de connexion (35), ce trou traversant (38) débouchant à l'extérieur du boîtier (20), dans une zone en retrait externe (20c) du fond (20b), l'épaulement (37a) de l'élément isolant électrique (37) étant en butée contre la zone en retrait externe (20c), la partie à section la plus faible (37.1) de l'élément isolant électrique, se projetant à l'intérieur du boîtier (20) à travers le
trou traversant (38), la tête (36.2) de la partie conductrice centrale (36) et la partie à section la
plus grande (37.2) de l'élément isolant électrique (37) restant à l'extérieur du boîtier (20).

2. Composant électronique selon la revendication 1, dans lequel chaque trou traversant (38) est décalé par rapport au bord du boîtier (20).

3. Composant électronique selon l'une des revendications 1 ou 2, dans lequel le fond (20b) du boîtier (20) comporte de plus une seconde zone en retrait externe (20d), de surface supérieure à celle de la première zone en retrait externe (20c) et qui englobe la première zone en retrait externe (20c), la première zone en retrait externe (20c) ayant une profondeur (e1) supérieure à celle de la seconde zone en retrait externe (20c).

4. Composant électronique selon l'une des revendications 1 à 3, dans lequel la partie à section la plus faible (37.1) de l'élément isolant électrique (37) obture le trou traversant (38).

5. Composant électronique selon l'une des revendications 1 à 4, dans lequel le boîtier (20) comporte une partie inférieure (20.1) comportant le fond (20b) et une partie supérieure (20.2) ou capot qui est fixée de manière étanche à la partie inférieure (20.1).

6. Composant électronique selon la revendication 5, dans lequel le capot (20.2) est collé à la partie inférieure (20.1).

7. Composant électronique selon la revendication 6, dans lequel le capot (20.2) est fixé par au moins une vis (30) à la partie inférieure (20.1).

8. Composant électronique selon l'une des revendications 1 à 7, dans lequel l'élément isolant électrique (37) du plot de connexion (35) est réalisé en matériau à constante diélectrique sensiblement constante et capable de supporter la température de fonctionnement, tel le Téflon.

9. Composant électronique selon l'une des revendications 1 à 8, dans lequel la partie conductrice centrale (36) du plot de connexion (35) est réalisée en cuivre doré, en laiton doré.

10. Composant électronique selon l'une des revendications 1 à 9, dans lequel le boîtier (20) est
réalisé en acier doré ou argenté, en alliage à coefficient de dilatation thermique aussi faible que possible tel que l'Invar, le Kovar, le Dilver.

11. Composant électronique selon l'une des revendications précédentes, **caractérisé en ce que** c'est un composant électronique hyperfréquence de type cirulateur et/ou isolateur éventuellement associés à
au moins une fonction telle un filtre, un limiteur de puissance.

## Patentansprüche

1. Elektronisches Bauteil zur Oberflächenmontage, enthaltend ein Gehäuse (20), eine elektronische Schaltung (22), die innerhalb des Gehäuses aufgenommen ist, zumindest zwei Anschlussstücke (35), die dazu bestimmt sind, eine elektrische Verbindung zwischen der elektronischen Schaltung (22) und einer gedruckten Schaltung (100) zu gewährleisten, an welche das Bauteil zu montieren ist, wobei jedes der Anschlussstücke (35) ein leitfähiges Mittelteil (36) in Nagelform mit einem Mittelsteg (36.1), der mit der elektronischen Schaltung (22) zu verbinden ist, und mit einem Kopf (36.2), der für einen elektrischen Kontakt mit der gedruckten Schaltung (100) sorgen soll, und ein elektrisch isolierendes Teil (37) aufweist, das den Mittelsteg (36.1) umgibt, **dadurch gekennzeichnet, dass** das elektrisch isolierende Teil (37) ein im Wesentlichen zylindrischer Ring ist, der zwei Abschnitte (37.1, 37.2) mit unterschiedlichen Querschnitten aufweist, die eine Schulter (37a) definieren, und dass das Gehäuse (20) einen Boden (20b) besitzt, der mit einem durchgehenden Loch (38) für jedes der Anschlussstücke (35) versehen ist, wobei dieses durchgehende Loch (38) auf der Außenseite des Gehäuses (20) in einem äußeren rückspringenden Bereich (20c) des Bodens (20b) ausmündet, wobei die Schulter (37a) des elektrisch isolierenden Teils (37) in Anschlag an dem äußeren Rücksprungbereich (20c) liegt, wobei der im Querschnitt geringere Abschnitt (37.1) des elektrisch isolierenden Teils sich im Inneren des Gehäuses (20) durch das durchgehende Loch (38) hindurch erstreckt, wobei der Kopf (36.2) des leitfähigen Mittelteils (36) und der im Querschnitt größere Abschnitt (37.2) des elektrisch isolierenden Teils (37) außerhalb des Gehäuses (20) verbleiben.

2. Elektronisches Bauteil nach Anspruch 1, wobei jedes durchgehende Loch (38) gegenüber dem Rand des Gehäuses (20) versetzt ist.

3. Elektronisches Bauteil nach einem der Ansprüche 1 oder 2, wobei der Boden (20b) des Gehäuses (20) ferner einen zweiten äußeren Rücksprungbereich (20d) aufweist, dessen Fläche größer ist als die des ersten äußeren Rücksprungbereichs (20c) und der den ersten äußeren Rücksprungbereich (20c) umschließt, wobei der erste äußere Rücksprungbereich (20c) eine Tiefe (e1) hat, die größer als die des zweiten äußeren Rücksprungbereichs (20c) ist.

4. Elektronisches Bauteil nach einem der Ansprüche 1 bis 3, wobei der im Querschnitt geringere Abschnitt (37.1) des elektrisch isolierenden Teils (37) das durchgehende Loch (38) verschließt.

5. Elektronisches Bauteil nach einem der Ansprüche 1 bis 4, wobei das Gehäuse (20) einen unteren Abschnitt (20.1) aufweist, der den Boden (20b) enthält, und einen oberen Abschnitt (20.2) oder eine Kappe, der/die in dichter Weise an den unteren Abschnitt (20.1) befestigt ist.

6. Elektronisches Bauteil nach Anspruch 5, wobei die Kappe (20.2) mit dem unteren Abschnitt (20.1) verklebt ist.

7. Elektronisches Bauteil nach Anspruch 6, wobei die Kappe (20.2) über zumindest eine Schraube (30) an den unteren Abschnitt (20.1) befestigt ist.

8. Elektronisches Bauteil nach einem der Ansprüche 1 bis 7, wobei das elektrisch isolierende Teil (37) des Anschlussstücks (35) aus einem Material mit im Wesentlichen konstanter dielektrischer Konstante ausgeführt und in der Lage ist, der Betriebstemperatur standzuhalten, wie etwa Teflon.

9. Elektronisches Bauteil nach einem der Ansprüche 1 bis 8, wobei das leitfähige Mittelteil (36) des Anschlussstücks (35) aus vergoldetem Kupfer oder vergoldetem Messing ausgeführt ist.

10. Elektronisches Bauteil nach einem der Ansprüche 1 bis 9, wobei das Gehäuse (20) aus vergoldetem oder versilbertem Stahl oder aus einer Legierung mit möglichst niedrigem Wärmeausdehnungskoeffizienten, wie Invar, Kovar, Dilver, ausgeführt ist.

11. Elektronisches Bauteil nach einem der vorangehenden Ansprüche, **dadurch gekennzeichnet, dass** es sich um ein elektronisches Ultrahochfrequenz-Bauteil vom Typ Zirkulator und/oder Isolator handelt, dem zumindest eine Funktion, wie etwa Filter, Leistungsbegrenzer, zugeordnet ist.

## Claims

1. Surface mounted electronic component comprising a housing (20), an electronic circuit (22) situated inside the housing, at least two connector pins (35) designed to provide an electrical interconnection between the electronic circuit (22) and a printed circuit (100) onto which the component is to be mounted, wherein each of the connector pins (35) comprises a central conductive part (36) in the form of a nail with a central core (36.1) to be connected to the electronic circuit (22) and a head (36.2), which is to provide an electrical contact with the printed circuit (100), and an electrically insulating element (37) which surrounds the central core (36.1), **characterised in that** the electrically insulating element (37) is a substantially cylindrical ring with two parts (37.1, 37.2) with different cross sections which define a shoulder (37a), and **in that** the housing (20) has a bottom (20b) which has a through hole (38) for each of the connector pins (35), wherein this through hole (38) opens out onto the outside of the housing (20), in a zone (20c) that is externally set back from the bottom (20b), wherein the shoulder (37a) of the electrically insulating element (37) abuts against the externally set back zone (20c), wherein the part with the smallest cross section (37.1) of the electrically insulating element protrudes inside the housing (20) via the through hole (38), and the head (36.2) of the central conductive part (36) and the part with the largest cross section (37.2) of the electrically insulating element (37) remains outside of the housing (20).

2. Electronic component according to claim 1, **characterised in that** each through hole (38) is offset with respect to the edge of the housing (20).

3. Electronic component according to any of claims 1 or 2, **characterised in that** the bottom (20b) of the housing (20) further comprises a second externally set back zone (20d), with a surface area that is larger than that of the first externally set back zone (20c) and which encloses the first externally set back zone (20c), wherein the first externally set back zone (20c) has a depth (e1) that is greater than that of the second externally set back zone (20c).

4. Electronic component according to any of claims 1 to 3, **characterised in that** the part with the smallest cross section (37.1) of the electrically insulating element (37) seals the through hole (38).

5. Electronic component according to any of claims 1 to 4, **characterised in that** the housing (20) comprises a lower section (20.1) featuring the bottom (20b) and an upper section (20.2) or cover that is imperviously attached to the lower section (20.1).

6. Electronic component according to claim 5, **characterised in that** the cover (20.2) is glued to the lower section (20.1).

7. Electronic component according to claim 6, **characterised in that** the cover (20.2) is attached by at least one screw (30) to the lower section (20.1).

8. Electronic component according to any of claims 1 to 7, **characterised in that** the electrically insulating element (37) of the connector pin (35) is made from a material with a substantially constant dielectrical constant and is capable of withstanding the operating temperature, such as Teflon.

9. Electronic component according to any of claims 1 to 8, **characterised in that** the central conductive part (36) of the connector pin (35) is made of gold-plated copper or gold-plated brass.

10. Electronic component according to any of claims 1 to 9, **characterised in that** the housing (20) is made of gold- or silver-plated steel, of an alloy with a coefficient of thermal expansion that is as low as possible such as Invar, Kovar or Dilver.

11. Electronic component according to any of the previous claims, **characterised in that** it is a circulator and/or isolator type hyperfrequency electronic component that may possibly be associated to at least one function such as a filter or a power limiter.
